# FASCICULE DE BREVET EUROPEEN

(11) **EP 3 086 101 B1**
(45) Date de publication et mention de la délivrance du brevet: **18.05.2022**
(21) Numéro de dépôt: 15191131.0
(22) Date de dépôt: 22.10.2015
(51) Int. Cl.: G01J 1/42, H03B 1/00

(54) **IMAGEUR TÉRAHERTZ EN CHAMP PROCHE**
NAHFELD-TERAHERTZ-BILDAUFNEHMER
NEAR-FIELD TERAHERTZ IMAGING DEVICE

(30) Priorité: 21.04.2015 FR 1553569
(43) Date de publication de la demande: 26.10.2016
(73) Titulaire: STmicroelectronics SA, 92120 Montrouge (FR)
(72) Inventeur: SHERRY, Hani, 38000 Grenoble (FR)
(74) Mandataire: Cabinet Beaumont

(56) Documents cités:
- WO-A1-2010/105373
- FR-A1- 2 995 475
- US-A1- 2012 274 410
- US-A1- 2014 166 868
- RICHARD AL HADI ET AL: "A 1 k-Pixel Video Camera for 0.7 1.1 Terahertz Imaging Applications in 65-nm CMOS", IEEE JOURNAL OF SOLID-STATE CIRCUITS, IEEE SERVICE CENTER, PISCATAWAY, NJ, USA, vol. 47, no. 12, 1 décembre 2012 (2012-12-01), pages 2999-3012, XP011485429, ISSN: 0018-9200, DOI: 10.1109/JSSC.2012.2217851
- M. SCHNELL ET AL: "Nanofocusing of mid-infrared energy with tapered transmission lines", NATURE PHOTONICS, vol. 5, no. 5, 1 mai 2011 (2011-05-01), pages 283-287, XP055255603, UK ISSN: 1749-4885, DOI: 10.1038/nphoton.2011.33
- CHERYL FEUILLET-PALMA ET AL: "Strong near field enhancement in THz nano-antenna arrays", SCIENTIFIC REPORTS, vol. 3, 1 mars 2013 (2013-03-01), XP055256304, DOI: 10.1038/srep01361

## Description

### Domaine

La présente demande concerne des imageurs haute fréquence, par exemple térahertz, constitués à partir d'une matrice de pixels.

### Exposé de l'art antérieur

Les imageurs térahertz sont des dispositifs adaptés à capter l'image d'une scène à partir d'ondes térahertz, c'est-à-dire des ondes dont la fréquence est par exemple comprise entre 0,3 et 3 THz. Un imageur classique tel que décrit dans la demande de brevet US 2014/070103 de la demanderesse comprend un émetteur d'ondes térahertz pour illuminer une scène dont on souhaite obtenir l'image, et un capteur constitué d'une matrice de pixels qui reçoit des ondes térahertz provenant de la scène. Les imageurs térahertz sont utilisés dans de nombreuses applications dans lesquelles il est souhaitable de voir à travers certains matériaux d'une scène. En effet, les ondes térahertz pénètrent dans de nombreux matériaux diélectriques et dans les liquides non polaires, sont absorbées par l'eau, et sont presque entièrement réfléchies par les métaux. Les imageurs térahertz sont notamment utilisés dans les portiques de sécurité des aéroports pour voir à travers les vêtements d'un individu ou à travers une valise afin de détecter par exemple des objets métalliques.

La figure 1 est une reproduction de la figure 1 de la demande de brevet US 2014/070103. Le capteur 1 comprend une matrice 3 de pixels 5 adaptés à capter des ondes térahertz. Un décodeur de ligne 7 reçoit un signal de sélection de ligne 9 qui indique quelle ligne doit être lue, et fournit aux lignes de la matrice 3 un signal de commande 11 correspondant. La matrice de pixels fournit des signaux de sortie 13 pour chaque colonne de la matrice. Les signaux de sortie 13 sont couplés à un bloc de sortie 15 qui sélectionne et commande chaque colonne. La lecture des colonnes est commandée par un décodeur de colonne 17 couplé au bloc de sortie 15 et, dans cet exemple, les colonnes sont lues les unes après les autres. Le bloc de sortie 15 produit alors un signal de sortie 19 représentant la valeur du pixel 5 de la ligne et de la colonne sélectionnées. Le signal de sortie 19 est amplifié puis couplé à un convertisseur analogique-numérique 21.

Pour analyser le signal reçu, ce signal est combiné à un signal térahertz de référence fourni par un oscillateur 23. L'oscillateur 23 est disposé à l'extérieur de la matrice 3 et fournit un même signal térahertz à un grand nombre de pixels ou à tous les pixels du capteur 1. Cet oscillateur 23 est de préférence couplé à un émetteur d'ondes térahertz, non représenté, illuminant la scène à analyser.

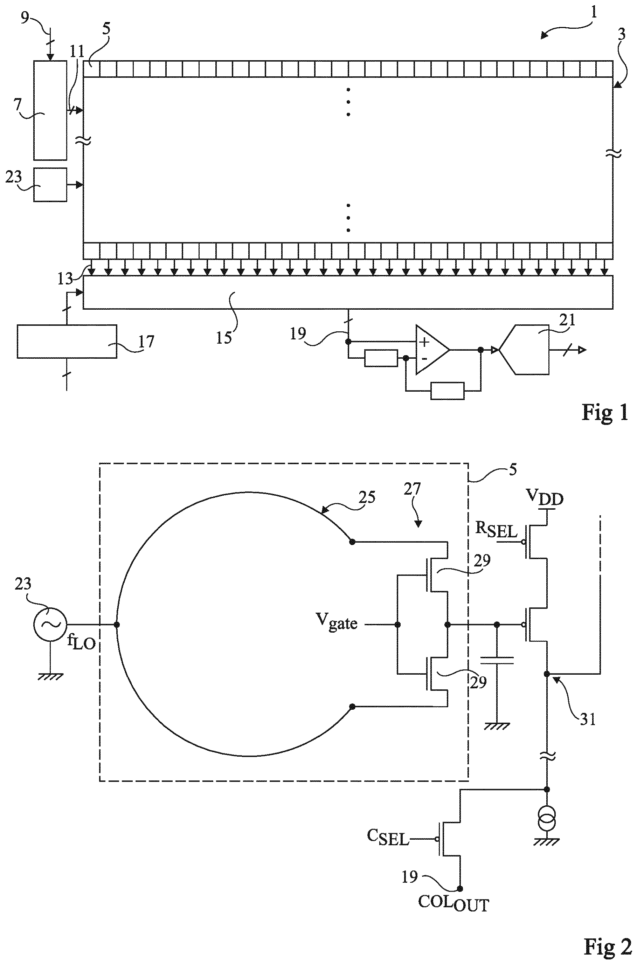

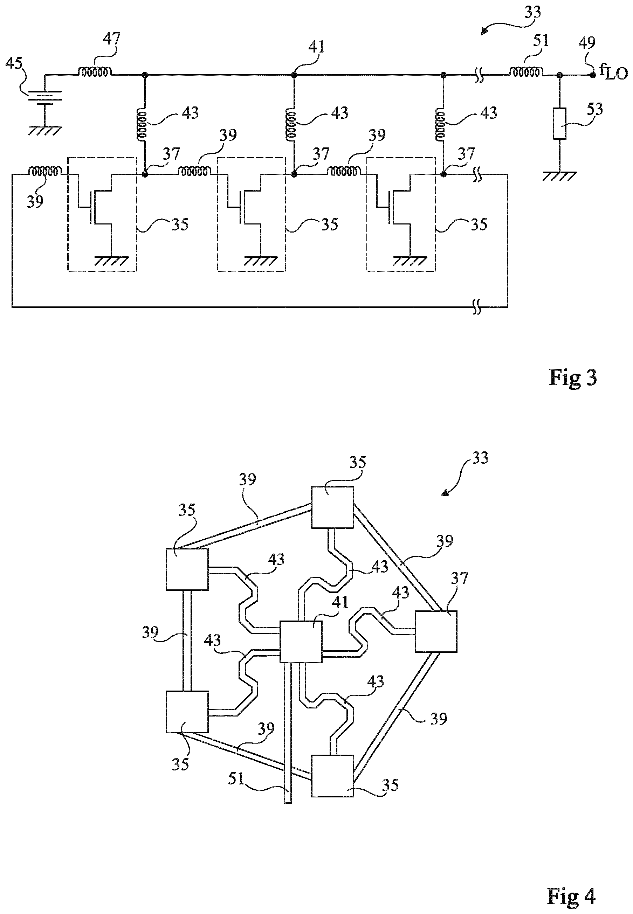

La figure 2 est une reproduction de la figure 3 de la demande de brevet US 2014/070103 et représente un exemple d'un pixel 5 du capteur 1. Le pixel 5 comprend une antenne détectrice 25 et un circuit de détection 27 constitué, dans cet exemple, de deux transistors NMOS 29 dont les grilles sont polarisées à un potentiel V_{gate}. L'antenne est couplée à l'oscillateur 23 représenté en figure 1 et au circuit de détection 27. La sortie du circuit de détection 27 est couplée à un circuit 31 de sélection de ligne et de colonne. Le circuit de sélection 31 est commandé par un signal R_{SEL} fourni par le décodeur de ligne 7 du capteur 1, et par un signal C_{SEL} fourni par le décodeur de colonne 17 du capteur 1. Le signal de sortie analogique 19 représentant la valeur du pixel 5 est disponible au niveau du noeud COL_{QUT} qui est couplé au convertisseur 21 du capteur 1.

La figure 3 est une reproduction de la figure 5 de la demande de brevet US 2014/070103 représentant un exemple de circuit d'un oscillateur d'un imageur térahertz. Le circuit 33 comprend un oscillateur en anneau constitué d'un nombre impair N d'inverseurs, trois dans cet exemple. Chaque inverseur est constitué d'un transistor NMOS 35 dont le drain est couplé à un noeud 37 et dont la source est couplée à la masse. Chaque noeud 37 est couplé par l'intermédiaire d'une inductance 39 à la grille du transistor 35 suivant, les inductances 39 ayant toutes la même valeur. Chaque noeud 37 est en outre couplé à un noeud sommateur 41 par l'intermédiaire d'une inductance 43, les inductances 43 ayant toutes la même valeur. Le noeud sommateur 41 est couplé à une source de tension continue 45 par l'intermédiaire d'une inductance 47, et à un noeud de sortie 49 de l'émetteur 33 par une inductance 51. Comme cela est représenté, le noeud de sortie 49 peut être couplé à la masse, par exemple par une résistance 53.

En fonctionnement, le signal généré par l'oscillateur en anneau comprend une composante sinusoïdale fondamentale de fréquence F, et des composantes sinusoïdales harmoniques dont une de fréquence N*F. La valeur de chaque inductance 43 est choisie pour réaliser un filtre passe-bande centré sur la fréquence N*F, et un signal de sortie de fréquence f_{LO} égale à N*F est disponible au niveau du noeud de sortie 49 de l'émetteur 33 qui est couplé à une antenne d'émission d'ondes térahertz.

La figure 4 est une reproduction partielle de la figure 8 de la demande de brevet US 2014/070103 et représente schématiquement un exemple de réalisation d'un circuit d'oscillateur 33 tel que décrit en relation avec la figure 3, mais à cinq inverseurs au lieu de trois. Dans cet exemple, chacune des inductances 39, 43 et 51 est mise en oeuvre sous forme d'une ligne de transmission.

L'imageur térahertz décrit en relation avec les figures 1 à 4 est un imageur en champ lointain conçu pour voir à travers certains matériaux d'objets volumineux éloignés ayant des dimensions supérieures à 10 cm, de préférence supérieures à 1 m. La résolution d'une image obtenue avec un imageur en champ lointain est au mieux de l'ordre de la longueur d'onde de fonctionnement de l'imageur, c'est-à-dire 1 mm à une fréquence de 300 GHz et 0,1 mm à une fréquence de 3 THz. Pour améliorer la résolution spatiale d'un imageur en champ lointain, on peut donc augmenter la fréquence de fonctionnement de l'imageur. Toutefois, cela pose de nombreux problèmes. Un imageur térahertz en champ lointain n'est donc pas adapté à l'obtention d'une image ayant une résolution de l'ordre de quelques dizaines de micromètres.

Des imageurs térahertz en champ proche permettent d'obtenir une image d'un objet à analyser avec une résolution de l'ordre de quelques dizaines de micromètres. Toutefois, ces imageurs sont complexes à mettre en oeuvre, notamment du fait qu'ils utilisent des sources d'émission térahertz telles que des rayonnements synchrotrons cohérents, et des systèmes optiques tels que des miroirs elliptiques. Un exemple d'imageur en champ proche est décrit dans l'article "THz near-field imaging of biological tissues employing synchrotron radiation" de Schade et al., publié en 2005 dans Ultrafast Phenomena in Semiconductors and Nanostructure Materials IX, 46.

Il serait donc souhaitable de disposer d'un imageur térahertz en champ proche qui soit aussi simple que possible et qui permette d'obtenir une image ayant une résolution de l'ordre de quelques dizaines de micromètres.

### Résumé

Ainsi, l'invention est définie par l'objet de la revendication 1.

Selon l'invention, le circuit de lecture de chaque pixel fournit un signal représentatif de la fréquence de l'oscillateur du pixel.

Selon un mode de réalisation, les lignes de transmission sont du type à microruban.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1, décrite précédemment, est une reproduction de la figure 1 de la demande de brevet US 2014/070103 représentant schématiquement un exemple d'un capteur d'imageur térahertz ;
la figure 2, décrite précédemment, est une reproduction de la figure 3 de la demande de brevet US 2014/070103 représentant schématiquement un exemple de pixel du capteur de la figure 1 ;
la figure 3, décrite précédemment, est une reproduction de la figure 5 de la demande de brevet US 2014/070103 représentant schématiquement un exemple d'un circuit d'oscillateur térahertz ;
la figure 4, décrite précédemment, est une reproduction partielle de la figure 8 de la demande de brevet US 2014/070103 représentant schématiquement un exemple de mise en oeuvre de l'émetteur de la figure 3 ;
la figure 5 est une vue de dessus schématique représentant une partie d'un exemple illustratif de pixels d'un imageur térahertz, selon une variante non conforme à l'invention.
la figure 6 est une vue en coupe selon le plan AA de la figure 5 et représente des lignes de transmission de l'imageur ; et
la figure 7 est une vue en coupe selon le plan BB de la figure 5 et représente une ligne de transmission écrantée de l'imageur.

### Description détaillée

De mêmes éléments ont été désignés par de mêmes références dans les différentes figures et, de plus, les diverses figures ne sont pas tracées à l'échelle. Dans la description qui suit, les termes "dessus" et "supérieur" se réfèrent à l'orientation des éléments concernés dans les figures correspondantes. Sauf précision contraire, les expressions "environ" et "de l'ordre de" signifient à 10 % près, de préférence à 5 % près, de la valeur indiquée.

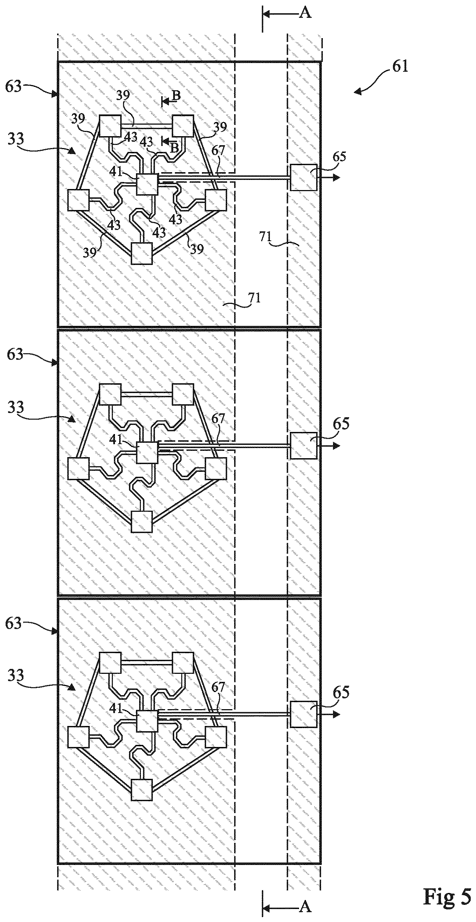

La figure 5 est une vue de dessus schématique d'un imageur térahertz non conforme à l'invention, une partie seulement de l'imageur étant représentée dans cette figure. L'imageur comprend une matrice 61 de pixels 63, trois pixels d'une colonne de la matrice 61 étant représentés en figure 5. Chaque pixel comprend un oscillateur 33, par exemple tel que décrit en relation avec les figures 3 et 4, un circuit de lecture 65, et une ligne de transmission 67. Une extrémité de la ligne 67 est couplée au noeud 41 l'oscillateur 33 et l'autre extrémité est couplée au circuit de lecture 65. Le circuit de lecture de chaque pixel est adapté à fournir un signal représentatif de la valeur de l'impédance de la ligne 67. Le circuit de lecture de chaque pixel est couplé à un circuit de sélection de ligne et de colonne (non représenté) commandé par un décodeur de ligne et un décodeur de colonne (non représentés). Dans cet exemple non conforme à l'invention, l'oscillateur 33 et, dans certains exemples, le circuit de détection 65 de chaque pixel 63 sont écrantés par une couche de blindage 71, par exemple une couche métallique, bloquant la propagation des ondes haute fréquence.

En fonctionnement, l'oscillateur 33 de chaque pixel est polarisé par une source de tension continue couplée à la ligne de transmission 67, par exemple au niveau du circuit de détection 65 du pixel. L'oscillateur 33 fournit alors un signal térahertz de fréquence f et de longueur d'onde λ à la ligne de transmission 67.

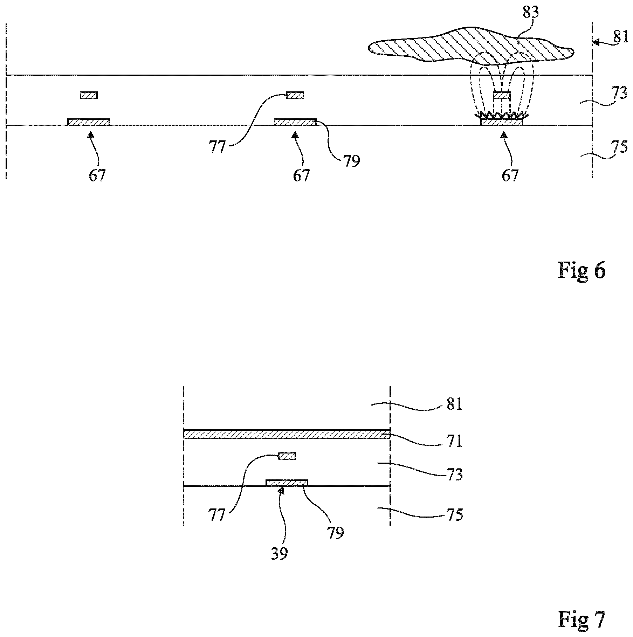

Les figures 6 et 7 sont respectivement une vue en coupe selon le plan AA de la figure 5 et une vue en coupe selon le plan BB de la figure 5.

La figure 6 représente trois lignes de transmission 67 de trois pixels 63 de l'imageur de la figure 5. Les lignes de transmission 67 sont formées dans des niveaux de métallisation noyés dans une couche isolante 73 reposant sur un support semiconducteur 75. Chaque ligne de transmission comprend un microruban 77 au-dessus d'une bande conductrice 79 formant un plan de masse. Le microruban de chaque ligne de transmission est surmonté d'une couche isolante d'épaisseur inférieure à λ, et de préférence à 0,1 λ, λ étant la longueur d'onde du signal de l'oscillateur couplé à la ligne.

Un objet à analyser 81 est disposé contre la face supérieure ou face active de la matrice de pixels de l'imageur. L'objet peut être constitué de plusieurs matériaux de constantes diélectriques différentes et présenter des inhomogénéités de constante diélectrique effective.

Lorsqu'un signal térahertz de fréquence f et de longueur d'onde λ est appliqué à une ligne 67, des champs térahertz rayonnent du microruban 77 au plan de masse 79, comme cela est représenté en pointillés pour le pixel de droite de la figure 5, et une partie de ces champs fuit hors des éléments de l'imageur. Ces champs térahertz pénètrent dans une couche superficielle de l'objet à analyser 81. On appelle "profondeur d'analyse" de l'imageur l'épaisseur de la couche superficielle de l'objet dans laquelle pénètrent ces ondes térahertz. La profondeur d'analyse est de l'ordre de quelques longueurs d'onde λ, par exemple de 1 à 3*λ, c'est-à-dire 0,1 à 0,3 mm si la fréquence f est égale à 3 THz, et de 1 à 3 mm si la fréquence f est égale à 300 GHz.

L'impédance d'une ligne de transmission 67 dépend de la constante diélectrique effective des éléments de l'imageur et du matériau de l'objet 81 qui se trouve au-dessus de la ligne et sera donc différente pour les deux pixels disposés à droite en figure 6, sous une inhomogénéité 83, et pour le pixel disposé à gauche en figure 6. Une image des constantes diélectriques des matériaux de la couche superficielle de l'objet 81 est alors obtenue à partir de l'ensemble des signaux de sortie des pixels de l'imageur. La résolution de l'imageur correspond donc aux dimensions de ses pixels. Par exemple, dans le cas d'un oscillateur 33 à cinq inverseurs délivrant un signal à 600 GHz, chaque pixel peut avoir de 20 à 50 µm de côté.

Une caractéristique des pixels décrits précédemment est que la ligne de transmission 67 de chaque pixel sert d'émetteur d'ondes térahertz pour illuminer une portion d'un objet à analyser, et sert également de détecteur pour capter un signal associé à la constante diélectrique effective de cette portion.

A titre d'exemple, le support semiconducteur 75 est un substrat de silicium massif ou de type SOI ("Silicon On Insulator" - silicium sur isolant) dans lequel sont formés des composants électroniques de l'imageur, notamment les transistors des pixels. Ce support est revêtu de niveaux de métallisation d'une structure d'interconnexion des composants électroniques formés dans le support semiconducteur. Les microrubans 77 et les plans de masse 79 des lignes de transmission 67 sont formés dans ces niveaux de métallisation.

Dans un exemple d'application, l'objet 81 analysé par l'imageur de la figure 5 est la peau d'un patient dans laquelle on cherche à localiser l'emplacement de cellules cancéreuses. Si, par exemple, les cellules cancéreuses comprennent plus d'eau que des cellules saines, leur constante diélectrique n'est pas la même que celle des cellules saines et cette inhomogénéité de constante diélectrique pourra être détectée et localisée.

Dans un autre exemple d'application, l'objet à analyser 81 est un liquide, par exemple du sang, dans lequel on cherche à connaître la concentration et/ou le mouvement d'éléments solides en suspension de constante diélectrique différente de celle du liquide.

La figure 7 est une vue en coupe selon le plan BB de la figure 5 et représente une ligne de transmission écrantée, en l'espèce une ligne 39. La ligne de transmission 39 est formée dans des niveaux de métallisation de même que la couche de blindage 71. La présence de la couche de blindage 71 entraine que le fonctionnement de la ligne ne dépend pas des matériaux de la couche superficielle de l'objet à analyser.

Cependant, selon l'invention, les lignes 39 et 43 ne sont pas écrantées. L'impédance des lignes 39 et 43 de chaque pixel dépend alors de l'objet vu par ce pixel, et la fréquence f de l'oscillateur varie en conséquence. On peut mesurer les fréquences f et/ou les variations de la tension ou du courant de sortie des pixels de l'imageur pour reconstruire une image des matériaux de la couche superficielle de l'objet à analyser. En fait, on peut adapter la conception des lignes de transmission et des oscillateurs pour être sensible à des plages spécifiques de constantes diélectriques, ou être large bande.

Un mode de réalisation particulier a été décrit. Diverses variantes et modifications apparaîtront à l'homme de l'art. En particulier, des lignes de transmission différentes de celles décrites précédemment peuvent être utilisées, par exemple des lignes de transmission coplanaires.

L'oscillateur contenu dans chaque pixel peut être remplacé par un autre oscillateur, par exemple par l'oscillateur décrit dans l'article "A 283-to-296GHz VCO with 0.76mW Peak Output Power in 65nm CMOS" de Y. M. Tousi et al., publié dans Solid-State Circuits Conférence Digest of Technical Papers (ISSCC), 2012 IEEE International, pages 258 à 260.

En pratique, les pixels de l'imageur ne sont pas tous lus en même temps, par exemple les pixels sont lus séquentiellement, un par un. On peut alors éteindre les pixels qui ne sont pas en train d'être lus, par exemple en ne polarisant pas les oscillateurs de ces pixels.

On peut prévoir que la matrice d'un imageur permette d'analyser la couche superficielle avec plusieurs profondeurs d'analyse. On peut par exemple prévoir que les lignes de certains groupes de pixels soient revêtues d'une couche isolante plus épaisse que celle d'autres groupes de pixels. On peut aussi prévoir que les oscillateurs de certains groupes de pixels fonctionnent à des fréquences différentes de celles d'autres groupes de pixels.

## Revendications

1. Imageur haute fréquence en champ proche Z comprenant une matrice de pixels, chaque pixel comprenant :
un oscillateur haute fréquence (33) oscillant à une fréquence choisie dans une plage de 0,3 à 3 THz et comprenant des premières lignes de transmission (39, 43) ;
une seconde ligne de transmission (67) dont une première extrémité est couplée à l'oscillateur ; et
un circuit de lecture (65) couplé à une deuxième extrémité de la seconde ligne et comprenant des moyens de mesure de la fréquence de l'oscillateur,
dans lequel chaque ligne de transmission est surmontée d'une couche isolante (73) dont l'épaisseur est inférieure à la longueur d'onde de fonctionnement de l'oscillateur et dont la face supérieure est destinée à être au contact d'un objet à analyser.

2. Imageur selon la revendication 1, dans lequel les lignes de transmission sont du type à microruban.

## Patentansprüche

1. Nahfeld-Hochfrequenz-Bildgeber mit einer Pixelmatrix, wobei jedes Pixel Folgendes aufweist:
einen Hochfrequenzoszillator (33), der mit einer in einem Bereich von 0,3 bis 3 THz gewählten Frequenz schwingt und erste Übertragungsleitungen (39, 43) aufweist;
eine zweite Übertragungsleitung (67), deren erstes Ende mit dem Oszillator gekoppelt ist; und
eine Leseschaltung (65), die mit einem zweiten Ende der zweiten Leitung gekoppelt ist und Mittel zum Messen der Frequenz des Oszillators aufweist,
wobei jede Übertragungsleitung von einer Isolierschicht (73) überragt wird, deren Dicke geringer ist als die Betriebswellenlänge des Oszillators und die eine Oberseite aufweist, die dazu bestimmt ist, mit einem zu analysierenden Objekt in Kontakt zu sein.

2. Bildgeber nach Anspruch 1, wobei die Übertragungsleitungen vom Mikrostreifentyp sind.

## Claims

1. A near-field high frequency imager comprising a pixel matrix, each pixel comprising:
a high frequency oscillator (33) oscillating at a frequency chosen in a range from 0.3 to 3 THz and comprising first transmission lines (39, 43);
a second transmission line (67) having a first end coupled to the oscillator; and
a read circuit (65) coupled to a second end of the second line and comprising means for measuring the frequency of the oscillator,
wherein each transmission line is surmounted by an insulating layer (73) having a thickness smaller than the operating wavelength of the oscillator and having an upper face intended to be in contact with an object to be analyzed.

2. The imager of claim 1, wherein the transmission lines are of the microstrip type.
